# EUROPEAN PATENT SPECIFICATION

(11) **EP 0 342 063 B1**
(45) Date of publication and mention of the grant of the patent: **27.07.1994**
(21) Application number: 89304862.9
(22) Date of filing: 12.05.1989
(51) Int. Cl.: C09K 11/88, C09K 11/85, C09K 11/61

(54) **Process for preparing an electroluminescent film**
Verfahren zur Herstellung eines elektrolumineszenten Films
Procédé de préparation d'un film électroluminescent

(30) Priority: 13.05.1988 JP 117943/88
(43) Date of publication of application: 15.11.1989
(73) Proprietor: SHARP KABUSHIKI KAISHA, Osaka 545 (JP)
(72) Inventor: Mikami, Akiyoshi, Yamatotakada-shi Nara-ken (JP); Tanaka, Koichi, Nara-shi Nara-ken (JP); Taniguchi, Kouji, Shiki-gun Nara-ken (JP); Yoshida, Masaru, Ikoma-gun Nara-ken (JP); Nakajima, Shigeo, Narashi Nara-ken (JP)
(74) Representative: Brown, Kenneth Richard

(56) References cited:
- WO-A-88/03161
- DE-A- 3 630 983
- WORLD PATENT INDEX LATEST, DERWENT FILE SUPPLIER, Derwent Publications Ltd, London, GB; & JP-A-62 079 285
- PATENT ABSTRACTS OF JAPAN, vol. 9, no. 125 (E-332)[1908], 31st July 1985; & JP-A-60 54 153

## Description

This invention relates to a process for preparing an electroluminescent (EL) film. More particularly, it relates to a process for preparing a thin EL film by employing a chemical vapor deposition (CVD) technique which enables the growth of a thin film of high quality on a mass-production basis. The thin film EL device which is produced by using the process of this invention allows multicolored luminescence with high brightness and is, therefore, applicable to a planar display of high quality for an electronic apparatus, a measuring instrument or the terminal component of a computer, and a planar television as well.

There has been known a thin film EL device which comprises an electroluminescent film made of a compound semi-conductor of Group II - VI elements, such as ZnS, ZnSe, Cas, SrS or SrSe, and doped with a rare earth element, such as Tb, Sm, Eu or Ce, for forming luminescent centers.

A typical thin film EL device which is practically employed comprises an electroluminescent film made of ZnS and doped with Mn forming luminescent centers, two insulating layers of high resistivity between which the electroluminescent film is sandwiched, a transparent electrode on the outside of one of the insulating layers and a back electrode on the outside of the other insulating layer.

In order to achieve a high degree of luminance and reliability, the electroluminescent film is required to contain a relatively high concentration of Mn in the range of 0.1 to 1 at.% and have a high degree of crystallinity. Two processes are practically used for preparing such an electroluminescent film. One of them is the electron-beam evaporation technique which employs sintered pellets of a mixture of ZnS and Mn. The other process is the atomic layer epitaxy (ALE) in which Zn, Mn and S are transported in vapor form to a substrate alternately to form mono layers of atoms one upon another (Japanese Patent Publication No. 35158/1982).

Attempts have been made to form EL devices by molecular beam epitaxy (MBE) (Tomoyoshi, et al.: "Molecular beam epitaxial ZnSe:Mn dc electroluminescent cell with very low threshold voltage", J. Appl. Phys., 52, Sept. 1981, pp.5797-5799), and by organometallic chemical vapour deposition (OMCVD) (Alan F. Cattell, et al.: "Electroluminescence From Films of ZnS: Mn Prepared by Organometallic Chemical Vapour Deposition", IEEE TRANSACTION ON ELECTRON DEVICES, vol. ED-30, No. 5, May 1983). Both of these processes are, however, still in the stage of basic research prior to practical use.

Proposals have been made in both JP-A-62-79285 (see, for example, WPIL, Derwent Publications Ltd) and DE-A-3630983 to form thin electroluminescent films by vapour deposition techniques. In the former, S, CaI₂, CeCl₃ and Se are heated and their vapours are co-deposited in sequence on a coated quartz substrate to form a polycrystal film of CaS₁₋ₓSeₓ:Ce. In the latter, SrI₂, Se and CeCl₃ are co-evaporated and deposited in turn on a transparent ZnO:Al electrode layer. Unlike JP-A-62-79285, DE-A-3630983 recognises that different vapour pressures are involved and compensates by evaporating the component materials at different temperatures.

Attempts have also been made to employ hydrogen or halogen transport chemical vapor deposition (CVD) for preparing a thin film of a single-crystal compound semiconductor of Group II - VI elements, such as ZnS, for the purpose of making a light-emitting diode or laser. There is, however, not known any case where this CVD technique has been employed to form an electroluminescent film for a thin film EL device by simultaneously doping an element forming luminescent centers which is a kind of impurity.

The EL device is essentially required to have a thin and highly crystalline electroluminescent film in order to realize a high degree of luminance and a reduction in driving voltage. Moreover, it is desirable to employ a film-forming process which makes it possible to dope the film with a high concentration of Mn in a stable and accurately controllable way.

While electron beam evaporation technique is a process which allows a high film-forming speed and suitable for use on a mass-production basis, it can form only a film of low crystallinity, since the three-dimensional growth of a nucleus occurs during the initial stage of film formation. The film is, therefore, required to have a large thickness in order to achieve a high degree of luminance, and necessarily brings about an increase in driving voltage. The low crystallinity is also the cause of a reduction in reliability of the film property.

As the film which has been formed by ALE is a product of the two-dimensional growth, it is of high crystallinity and can, therefore, realize a high degree of luminance and a reduction in driving voltage. This process, however, allows a film to grow only very slowly and is, therefore, not suitable for use on a mass-production basis.

While MBE can also form a film of high crystallinity, it has the drawback of being unable to form a film having a large area and lacking applicability on a mass-production basis. OMCVD has the drawback which is due to the fact that few kinds of organic materials are available for use as a dopant forming luminescent centers.

The present invention seeks to provide a process for preparing a high quality electroluminescent film having a large area by mass-production techniques, and is based on the finding that when the vapour of a halide of an element which forms luminescent centers is supplied to a substrate together with the vapour which forms a Group II - VI, compound semiconductor under CVD condition, a thin high quality electroluminescent film can be efficiently formed on the substrate.

According to the invention, there is provided a process for forming an electro-luminescent film comprising a group II-VI compound semiconductor doped with luminescent centres, the process being characterised by:
forming a stream of a carrier gas of hydrogen or inert gas which contains in vapour form a group II element and a group VI element of a compound thereof capable of forming the group II-VI compound semiconductor, and which contains in vapour form a halide of an element capable of forming the luminescent centres, in amounts to provide transportation rates of the vapours of 10⁻³ to 10⁻⁵ mol/min of each of the group II element and the group VI element or of the compound thereof and of 10⁻⁴ to 10⁻⁶ mol/min of the halide,
passing the stream of carrier gas and entrained vapours over a substrate having a temperature of 400 to 600°C, and permitting the vapours to condense on the surface
of the substrate to form an electro-luminescent film having a thickness of 0.3 to 1.0 µm.

The invention enables the efficient production of electroluminescent films of high crystallinity doped with a high concentration of an element forming luminescent centers. The process of this invention is suitable for the formation of a film having a large area and the mass production of any such film, as it is based on a chemical vapor deposition technique. It enables the realization of an electroluminescent device which can be driven at a lower voltage to emit light having a high degree of luminance. Therefore, the process of this invention has a high industrial value as compared with any conventional method.

The invention is described below in greater detail by way of example only by reference to the accompanying drawings, in which:
Fig. 1 is a schematic view showing a chemical vapor deposition apparatus employed for carrying out a process of this invention, together with a graph showing the longitudinal temperature distribution of the reaction chamber which the apparatus includes;
Fig. 2 is a graph showing the rate of Mn transportation and the concentration of Mn in a film of ZnS in relation to the flow rate of HCl gas, based on the results obtained in the examples which will hereinafter be described;
Fig. 3 is a graph showing the voltage-luminance characteristics of a thin film EL device made by way of example as will hereinafter be described;
Fig. 4 is a diagram showing the spectrum of luminescence produced by the same device;
Fig. 5 is a graph showing the voltage-luminance characteristics with the luminous efficiency of a thin film EL device made by way of example as will hereinafter be described; and
Fig. 6 is a graph showing the concentration of Mn in an electroluminescent film and its luminance in relation to the rate of Mn transportation and the substrate temperature, based on the results obtained in the example.

According to the process of this invention, the substrate on which an electroluminescent film is going to be formed is usually placed in a CVD chamber through which a hydrogen or inert gas as a carrier gas is flowing. When an inert gas is employed, it is possible to use, for example, argon, helium or nitrogen gas.

The substrate is heated to, and held at, an appropriate high temperature at which the growth of a film from a vapor phase is going to take place, that is to say at 400°C to 600°C.

The growth of the film from a vapor phase is effected by supplying (a) a Group II element and a Group VI element which are capable of forming a Group II - VI compound semiconductor, or a compound of those elements, and (b) a halide of an element for forming luminescent centers, both in vapor form, to flow simultaneously into contact with the substrate surface at a high temperature.

The Group II element which is employed may, for example, be Zn, Cd, Ca or Sr and the Group VI element may, for example, be S, Se or O. The compound of those elements may, for example, be ZnS, ZnSe, SrS or CaS. As these elements or compounds are solid at ordinary temperatures, they are vaporized by heating to an appropriate temperature in the presence of flowing hydrogen or inert gas and the resulting vapor is transported to the substrate. If, for example, ZnS is employed, it is usually heated to a temperature of 800°C to 1000°C and the resulting vapor thereof is transported at a speed of ca. 10⁻⁵ to 10⁻³ mol per minute.

The element which is employed for forming luminescent centers may be Mn or a rare earth element, such as Tb, Sm, Eu, Lu or Ce. The halide thereof which is used may, for example, be a fluoride, chloride, bromide or iodide. It is particularly preferable to use a chloride, such as MnCL₂, TbCl₃ or EuCl. As the halide which is employed is also solid at ordinary temperatures, it is vaporized by heating and its vapor is supplied to the substrate. However, it is alternatively possible to heat Mn or a rare earth element, or a compound thereof other than the halides (e.g. oxide or sulfide) to an appropriate temperature (e.g. 600°C to 800°C if Mn is employed), while supplying it with gas of a hydrogen halide, such as hydrogen chloride, thereby producing in situ vapor of the halide of Mn or a rare earth element which is continuously supplied to the substrate with the Group II and VI elements. This method has the advantage of being able to form an electroluminescent film of particularly good quality.

When the halide which is employed is, for example, MnCl₂, it is appropriate to transport it at a rate of ca. 10⁻⁴ to 10⁻⁶ mol per minute.

According to the invention, since all of the elements used to form an electroluminescent film are simultaneously supplied to flow into contact with the substrate surface under a specific conditions as hereinabove described, it is possible to grow thereon an electroluminescent film which comprises a Group II - VI compound semiconductor of high density and crystallinity as a matrix and doped with a high concentration (i.e. 0.1 to 1 at. %) of an element forming luminescent centers. The period of time for effecting the process of the invention is preferably so controlled as to form an electroluminescent film having a thickness of 0.3 to 1.0 micron which is suitable for a thin film EL device.

Thus, the process of this invention enables the continuous formation of an electroluminescent film of high crystallinity doped with a high concentration of a luminescent center-forming element in a single step of operation by simultaneously effecting the vapor-phase growth of its matrix on the substrate surface and the transportion of a halide of the luminescent center-forming element thereto.

### EXAMPLES

### EXAMPLE 1:

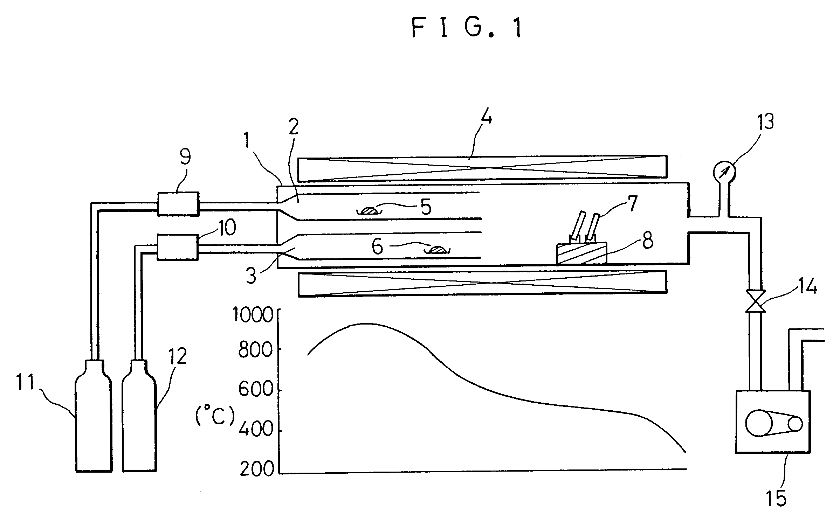

Description will now be made of the results which were obtained when a powder of ZnS was heated at a high temperature and the resulting vapor thereof was transported to a deposition zone by hydrogen gas to form a film of ZnS. Similar results to those described hereinbelow were also obtained when argon gas was used instead of hydrogen, and when the individual elements of Zn and S were used instead of the ZnS powder. The apparatus which was employed for carrying out a process embodying this invention is shown in Fig. 1.

The apparatus included a reaction chamber which comprised a main tube 1 of quartz having a length of 1 m and an inside diameter of 5 cm, two vapor supplying tubes 2 and 3 disposed in the main tube 1 and each having a length of 50 cm and an inside diameter of 2 cm, and an electric furnace 4 surrounding the main tube 1. The chamber had a longitudinal temperature distribution as shown graphically in Fig. 1.

A quartz boat containing a powder of ZnS 5 was placed in that portion of the vapor supplying tube 2 which had a temperature of about 930°C, while another quartz boat containing a powder of Mn 6 as a material for forming luminescent centers was positioned in that portion of the tube 3 which had a temperature of about 750°C. Hydrogen gas was supplied from a bottle 11 of hydrogen to the tube 2 at a rate of 100 cc per minute for transporting the resulting vapor of ZnS. When argon gas was employed instead of hydrogen, it was found to enable the growth of a film in a similar way, though it showed an about 10% lower rate of vapor transportation. Hydrogen chloride gas was supplied from a bottle 12 of hydrogen chloride to the tube 3 at a rate of 0.1 to 1.5 cc per minute for forming vapor of manganese chloride as a result of the reaction shown by formula I, and transporting it to the deposition zone:

Mn + 2HCl → MnCl₂ + H₂ (I)

The vapors of ZnS and MnCl₂ were transported to the deposition zone in which a glass substrate 7 on which ITO, SiO₂ and Si₃ N₄ films had been formed by radio frequency sputtering was supported on a substrate holder 8 at an inclination to the vertical. The surface of the substrate 7 was left in contact with the vapors for a period of 60 minutes, whereby an electroluminescent film was formed thereon. Then, Si₃N₄ and Al₂O₃ films were formed on the electroluminescent film by radio frequency sputtering, and an Al film on the Al₂O₃ film by vacuum evaporation, whereby an EL device was obtained.

In Fig. 1, 9 and 10 are mass flow controllers, 13 is a pressure gage, 14 is a main valve, and 15 is an oil pump.

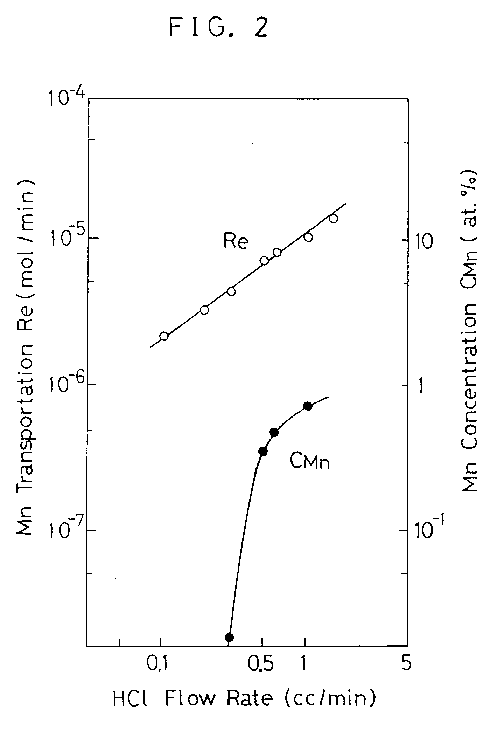

Various electroluminescent films of ZnS were formed by varying the flow rate of HCl gas and employing the same apparatus and conditions as hereinabove described, and then the transportation rate of the produced MnCl₂ and the Mn concentration of the ZnS film were examined in relation to the flow rate of HCl gas. The Mn concentration of each film was determined by an electron-beam probe X-ray microanalyzer. The results are shown in Fig. 2. As is obvious from Fig. 2, the rates of Mn transportation were substantially proportional to the flow rates of HCl gas; in other words, Mn could be transported in a well-controlled way as a result of the reaction shown by formula I above, The Mn concentration of the ZnS film showed a sharp increase when the flow rate of HCl gas exceeded 0.3 cc/min., and when the flow rate of HCl gas was from 0.5 to 0.6 cc/min., the films were doped with 0.3 to 0.5 at. % of Mn which is within the known range of the optimum Mn concentration of the ZnS film in an EL device.

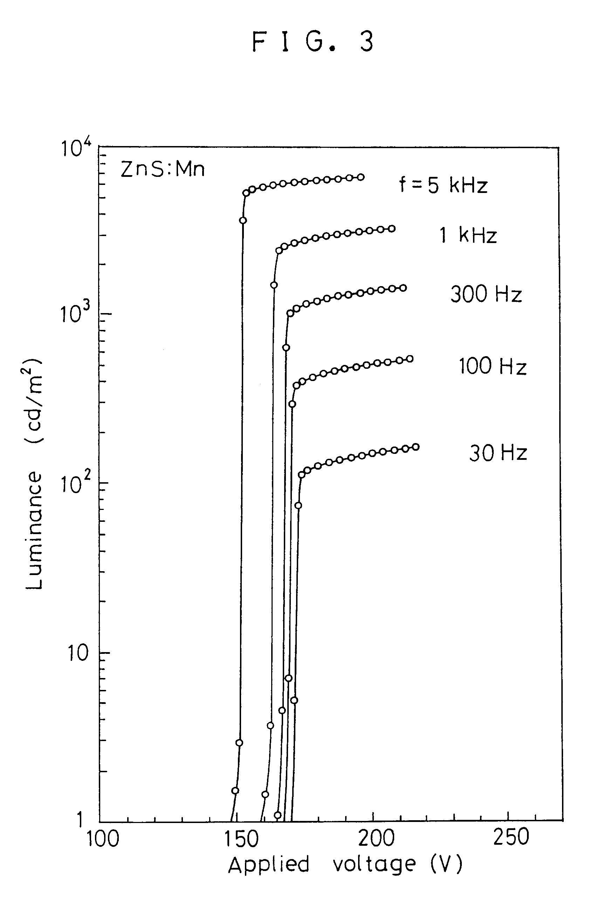

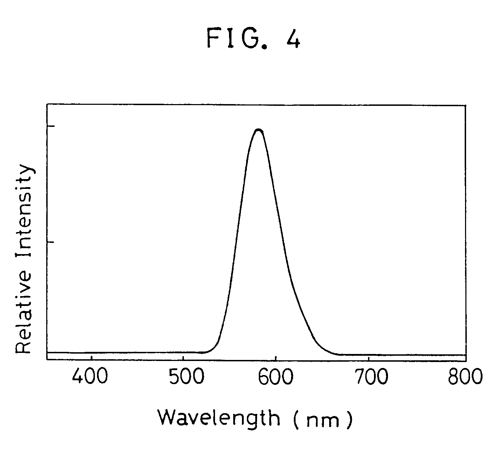

An EL device was made by employing the ZnS film containing 0.46 at. % of Mn and having a thickness of 0.65 µm. Fig. 3 shows the voltage-luminance characteristics of the device and Fig. 4 shows the spectrum of the luminescence at a frequency of 1 kHz. As is obvious therefrom, the device emitted light having a yellowish orange color and a wavelength of about 580 nm and when it was driven at a frequency of 1 kHz, it showed a luminance as high as about 3000 cd/m² (876 ft-L) upon application of a low voltage (150 - 170 V).

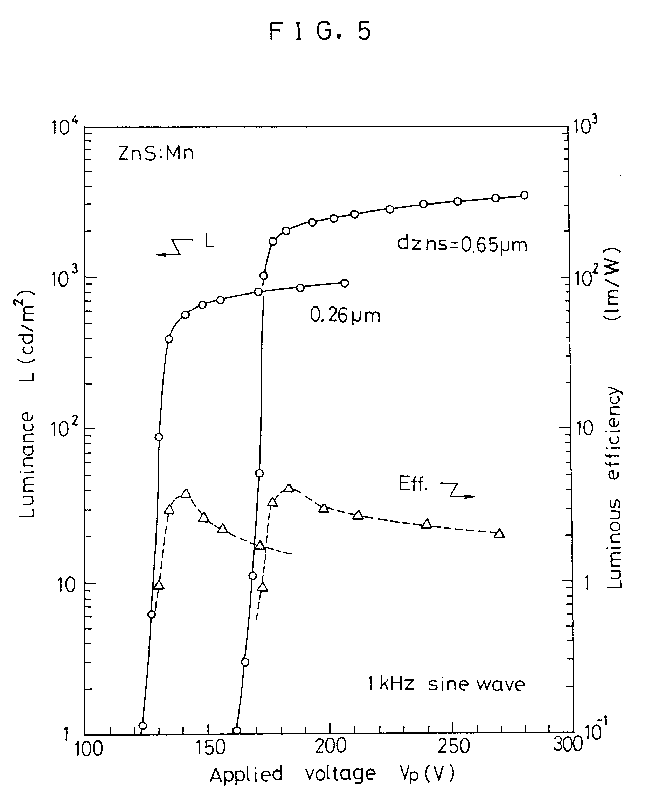

Fig. 5 shows the voltage-luminance characteristics with the luminous efficiency of the device using the ZnS film having a thickness of 0.26 µm or 0.65 µm which is prepared by the claimed invention. As is clear therefrom, quite thin ZnS film (0.26 µm) also allows a high luminous efficiency. This fact clearly shows the film being of high quality.

Although Mn has been described as having been employed as the material for forming luminescent centers, it was also possible to employ a compound thereof, such as MnS or MnO, and supply Mn in the form of a halide as a result of the reaction:

MnS + 2HCl → MnCl₂ + H₂S; or

MnO + 2HCl → MnCl₂ + H₂O

It was also possible to employ a hydrogen halide other than HCl, such as HBr, and supply Mn in the form of a halide as a result of the reaction:

Mn + 2HBr → MnBr₂ + H₂

Moreover, it was possible to employ a rare earth element (Lu), such as Tb or Sm, as the material for forming luminescent centers and supply it in the form of a halide as a result of the reaction:

2Lu + 6HCl → LuCl₃ + 3H₂

to dope an electroluminescent film with luminescent centers. When a halide, such as MnCl₂ or TbCl₃, was used as the material for forming luminescent centers, it was not necessary to use any hydrogen halide gas, but it was sufficient to heat it to supply vapor of the material for forming luminescent centers.

### EXAMPLE 2:

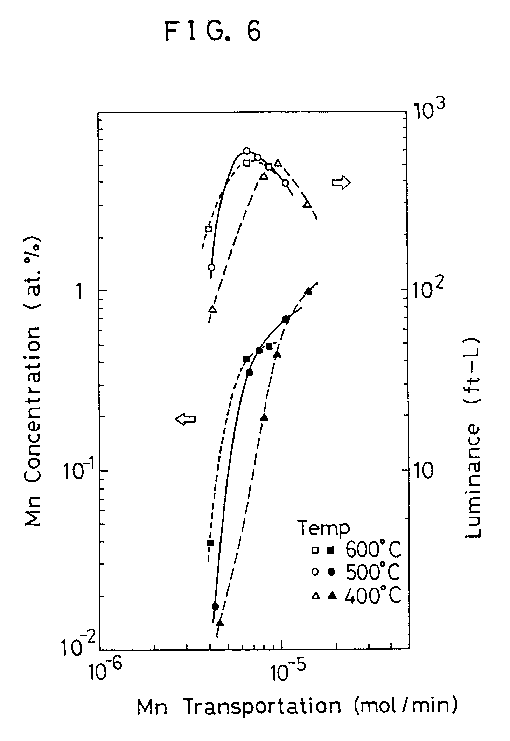

Electroluminescent films of ZnS each having a thickness of 0.5 micron were formed on substrates by employing different temperatures for heating the substrates and otherwise following EXAMPLE 1. The Mn concentrations of the films and the luminance obtained by driving at a frequency of 1 kHz were examined in relation to the rates of Mn transportation and substrate temperatures. The results are shown in Fig. 6. As is obvious therefrom, a particularly high concentration of Mn doping was achieved at a Mn (MnCl₂) transportation rate over about 5 x 10⁻⁶ mol/min. and the films having a Mn concentration of about 0.3 to 0.5 at. % showed the highest luminance.

### EXAMPLE 3:

The process of the invention was performed according to the procedure of EXAMPLE 1 except that a quartz tube having an inside diameter of 250 mm and a glass plate of 170 x 140 mm in size were used as a reaction chamber and a substrate, respectively.

Then, the electroluminescent film (Mn doped ZnS film) having a large area was uniformly formed over the substrate. The variation in the concentration of Mn for transverse direction and in the thickness of the film were within a range of ± 5% and ± 2%, respectively.

## Claims

1. A process for forming an electro-luminescent film comprising a group II-VI compound semiconductor doped with luminescent centres, the process being characterised by:
forming a stream of a carrier gas of hydrogen or inert gas which contains in vapour form a group II element and a group VI element of a compound thereof capable of forming the group II-VI compound semiconductor, and which contains in vapour form a halide of an element capable of forming the luminescent centres, in amounts to provide transportation rates of the vapours of 10⁻³ to 10⁻⁵ mol/min of each of the group II element and the group VI element or of the compound thereof and of 10⁻ ⁴ to 10⁻⁶ mol/min of the halide,
passing the stream of carrier gas and entrained vapours over a substrate having a temperature of 400 to 600°C, and
permitting the vapours to condense on the surface of the substrate to form an electro-luminescent film having a thickness of 0.3 to 1.0 µm.

2. The process of claim 1 in which the Group II element is Zn, Cd, Ca or Sr and the Group VI element is S, Se or O.

3. The process of claim 1 in which the compound of the elements of Group II and Group VI is ZnS, ZnSe, SrS or CaS.

4. The process of any preceding claim in which the element capable of acting as luminescent centres is Mn.

5. The process of claims 1 to 3 in which the element capable of acting as luminescent centres is a rare earth element Tb, Sm, Eu, Lu or Ce.

6. The process of any preceding claim in which the halide is a fluoride, chloride, bromide or iodide.

7. The process of claim 1 in which the vapour of the halide is formed by contacting Mn or a rare earth element or a compound thereof other than the halide with a flow of a hydrogen halide gas and supplied continuously in contact with the substrate.

8. The process of any preceding claim in which the inert gas is argon, helium or nitrogen gas.

9. The process of any preceding claim in which the electroluminescent film is doped with 0.1 to 1 at. % of an element forming luminescent centres.

10. The process of any preceding claim which is effected by using a CVD chamber.

## Patentansprüche

1. Verfahren zur Bildung eines elektrolumineszenten Films, umfassend einen mit lumineszenten Zentren dotierten Halbleiter einer Gruppe II-VI-Verbindung, wobei das Verfahren **dadurch gekennzeichnet** ist, daß man
einen Strom aus einem Trägergas aus Wasserstoff oder Inertgas bildet, welches in Dampfform ein Element der Gruppe II und ein Element der Gruppe VI oder eine Verbindung davon, welche in der Lage ist, den Halbleiter der Gruppe II-VI-Verbindung zu bilden, enthält, und welches in Dampfform ein Halogenid eines Elements, welches zur Bildung der lumineszenten Zentren fähig ist, enthält, und zwar in Mengen, um Transportraten der Dämpfe von jeweils 10⁻³ bis 10⁻⁵ Mol/min des Elements der Gruppe II und des Elements der Gruppe VI oder der Verbindung davon und von 10⁻⁴ bis 10⁻⁶ Mol/min des Halogenids vorzusehen,
den Strom aus Trägergas und mitgeführten Dämpfen über ein Substrat, welches eine Temperatur von 400 bis 600°C besitzt, leitet, und
die Dämpfe auf der Oberfläche des Substrats kondensieren läßt, um einen elektrolumineszenten Film mit einer Dicke von 0,3 bis 1,0 µm zu bilden.

2. Verfahren nach Anspruch 1, wobei das Element der Gruppe II Zn, Cd, Ca oder Sr und das Element der Gruppe VI S, Se oder O ist.

3. Verfahren nach Anspruch 1, wobei die Verbindung der Elemente der Gruppe II und der Gruppe VI ZnS, ZnSe, SrS oder CaS ist.

4. Verfahren nach einem der vorangehenden Ansprüche, wobei das Element, welches in der Lage ist, als lumineszente Zentren zu wirken, Mn ist.

5. Verfahren nach den Ansprüchen 1 bis 3, wobei das Element, welches in der Lage ist, als lumineszente Zentren zu wirken, ein Seltenerdelement Tb, Sm, Eu, Lu oder Ce ist.

6. Verfahren nach einem der vorangehenden Ansprüche, wobei das Halogenid ein Fluorid, Chlorid, Bromid oder Jodid ist.

7. Verfahren nach Anspruch 1, wobei der Dampf des Halogenids durch Kontaktieren von Mn oder eines Seltenerdelements oder einer von dem Halogenid verschiedenen Verbindung hiervon mit einem Strom eines Wasserstoffhalogenidgases gebildet und kontinuierlich im Kontakt mit dem Substrat zugeführt wird.

8. Verfahren nach einem der vorangehenden Ansprüche, wobei das Inertgas Argon, Helium oder Stickstoffgas ist.

9. Verfahren nach einem dervorangehenden Ansprüche, wobei der elektrolumineszente Film mit 0,1 bis 1 At.-% eines lumineszente Zentren bildenden Elements dotiert ist.

10. Verfahren nach einem der vorangehenden Ansprüche, welches unter Verwendung einer CVD-Kammer bewirkt wird.

## Revendications

1. Procédé pour former une couche électroluminescente comprenant un semiconducteur composé, constitué d'éléments des groupes II - VI dopé avec des centres de luminescence, le procédé étant caractérisé en ce qu'il consiste à :
former un courant d'un gaz porteur constitué par de l'hydrogène ou un gaz inerte, qui contient sous forme vapeur un élément du groupe II et un élément du groupe VI d'un composé de ces derniers capable de former le semiconducteur composé, constitué d'éléments des groupes II-VI, et qui contient sous forme vapeur un halogénure d'un élément capable de former les centres de luminescence, dans des quantités permettant d'assurer des vitesses de transport des vapeurs de 10⁻³ à 10⁻⁵ mole/min de l'élément du groupe II et de l'élément du groupe VI ou du composé de ces derniers, et de 10⁻⁴ à 10⁻⁶ mole/min de l'halogènure,
faire passer le courant du gaz porteur et des vapeurs entraînées sur un substrat dont la température est de 400 à 600°C, et
permettre aux vapeurs de se condenser sur la surface du substrat pour former une couche électroluminescente dont l'épaisseur est de 0,3 à 1,0 µm.

2. Procédé selon la revendication 1, dans lequel l'élément du groupe II est Zn, Cd, Ca ou Sr et l'élément du groupe VI est S, Se ou O.

3. Procédé selon la revendication 1, dans lequel le composé des éléments du groupe II et du groupe VI est ZnS, ZnSe, SrS ou CaS.

4. Procédé selon l'une quelconque des revendications précédentes, dans lequel l'élément capable d'agir comme centres de luminescence est le Mn.

5. Procédé selon les revendications 1 à 3, dans lequel l'élément capable d'agir comme centres de luminescence est un élément de terre rare Tb, Sm, Eu, Lu ou Ce.

6. Procédé selon l'une quelconque des revendications précédentes, dans lequel l'halogénure est un fluorure, chlorure, bromure ou iodure.

7. Procédé selon la revendication 1, dans lequel la vapeur de l'halogénure est formée en mettant en contact le Mn ou un élément de terre rare ou un composé de ceux-ci autre que l'halogénure avec un flux d'un halogénure d'hydrogène gazeux et est amenée de manière continue en contact avec le substrat.

8. Procédé selon l'une quelconque des revendications précédentes, dans lequel le gaz inerte est de l'argon, de l'hélium ou de l'azote.

9. Procédé selon l'une quelconque des revendications précédentes, dans lequel la couche électroluminescente est dopée avec 0,1 à 1 % at. d'un élément formant des centres de luminescence.

10. Procédé selon l'une quelconque des revendications précédentes, effectué à l'aide d'une chambre de dépôt chimique en phase vapeur.
